# EUROPEAN PATENT APPLICATION

(11) **EP 2 869 194 A1**
(43) Date of publication of application: **06.05.2015**
(21) Application number: 13872015.6
(22) Date of filing: 11.10.2013
(51) Int. Cl.: G06F 9/455

(54) **EXTENDED CACHE COHERENCE PROTOCOL-BASED MULTI-LEVEL COHERENCE DOMAIN SIMULATION VERIFICATION AND TEST METHOD**

(30) Priority: 18.01.2013 CN 201310018123
(71) Applicant: Inspur Electronic Information Industry Co., Ltd., Jinan City, Shandong 250014 (CN)
(72) Inventor: WANG, Endong, Jinan City Shandong 250014 (CN); HU, Leijun, Jinan City Shandong 250014 (CN); CHEN, Jicheng, Jinan City Shandong 250014 (CN); ZHANG, Feng, Jinan City Shandong 250014 (CN); ZHOU, Hengzhao, Jinan City Shandong 250014 (CN); FU, Yunyue, Jinan City Shandong 250014 (CN); GAN, Xiaowei, Jinan City Shandong 250014 (CN)
(74) Representative: Isern-Jara, Nuria
(86) International application number: PCT/CN2013/085028
(87) International publication number: WO 2014/110922

(57) **Abstract**

An extension Cache Coherence protocol-based multi-level coherency domain simulation verification and test method. An extension Cache Coherence protocol-based multi-level coherency domain CC-NUMA (Cache Coherent Non-Uniform Memory Access) system protocol simulation model is built, a protocol table inquiring and state converting executing mechanism in a key node of a system ensures that a Cache Coherence protocol is maintained in a single computing domain and is simultaneously maintained among a plurality of computing domains, and accuracy and stability of intra-domain and inter-domain transmission are ensured; a credible protocol inlet conversion coverage rate evaluation driven verification method is provided, transactions are processed by loading an optimized transaction generator push model, a coverage rate index is obtained after the operation is ended, and the verification efficiency is increased in comparison with a random transaction promoting mechanism. Through building a multi-processor multi-level coherency domain verification system model and performing relevant simulation verification, the applicability and the effectiveness of the method are further confirmed.

## Description

### Technical Field

The disclosure herein relates to the field of computer architecture , and in particular, to Cache coherence of a multi-processor computer system, a multi-node multi-processor computer system, a CC-NUMA (Cache Coherent Non-Uniform Memory Access) architecture, and a Cache Coherence protocol-based multi-level coherency domain and model test and verification method, and specifically, to an extension Cache Coherence protocol-based multi-level coherency domain simulation verification and test method.

### Background

Currently, a connection manner of multiple processors is changed from bus connection to point-to-point connection, and a memory is also directly hooked to the processor instead of being hooked to an external bridge chip of the processor. Because of the change of the memory hooking manner, distribution of the memory in the system is also changed, thereby causing non-uniformity of memory access in the multi-processor system, and therefore, current multi-processor systems are mostly Non-Uniform Memory Access (NUMA) architecture systems.

Multiple Cache units are distributed in a NUMA system, and therefore, the NUMA system shall be designed to solve the problem of coherence among multiple Caches. How to solve the Cache coherence problem is a core problem of the CC-NUMA system. Therefore, a verification work for a Cache coherence protocol is correspondingly an important part of a CC-NUMA system verification work. Under the impact of popularization of building a supercomputer by using commercially available microprocessors, building a CC-NUMA system by using commercially available multi-core microprocessors becomes an inevitable trend. In order to support the parallel of multiple processors, basically, almost all current high-end commercially available microprocessors support multi-path direct-connection extension. If processors use built-in memory controllers, and global access spaces are addressed uniformly, multiple directly connected processors may form a small CC-NUMA system. However, due to limited number of direct-connection interfaces of processors, it is difficult to build a large-scale system by only directly connecting the processors.

In order to implement a large-scale CC-NUMA multi-processor system, a Node Controller (NC) is required to extend a coherency domain space. The node controller in the disclosure herein has two functions including maintaining global Cache coherence and extending system scale: first, each node controller is connected to 1 to 4 processors, so as to form a node and a first-level Cache-coherency domain, and intra-domain coherence is collectively maintained by the processors and the node controller; next, node controllers are interconnected directly or are connected through a node router, so as to form a large-scale CC-NUMA system. Second-level Cache coherence among nodes is maintained by the node controllers. The large-scale CC-NUMA system built in this way needs to extend and establish a multi-layer protocol based on a processor direct-connection Cache coherence protocol, and maintain global coherence. The extension Cache Coherence protocol-based multi-level coherency domain CC-NUMA system protocol is always relatively complicated, and a simulation test is also very important; therefore, a simulation verification work for the protocol also becomes an important work.

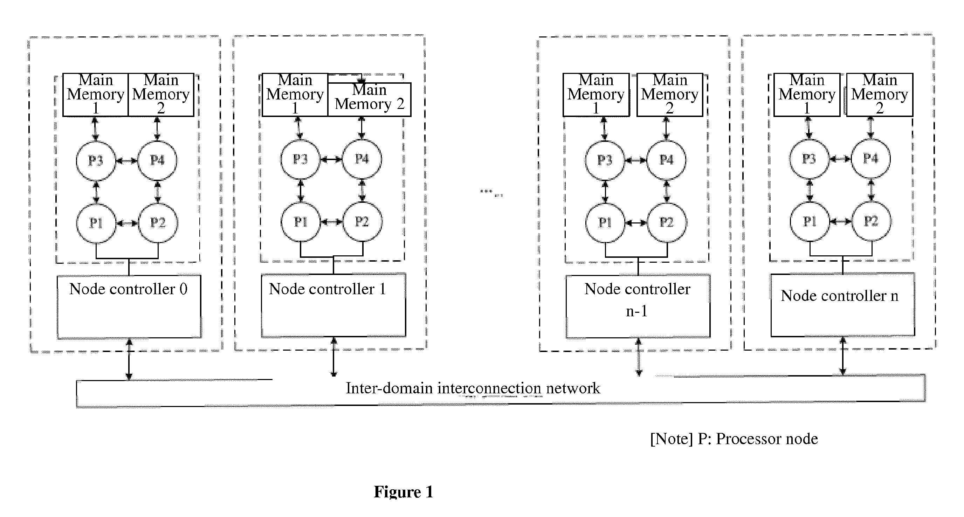

As described above, the multi-processor system built by directly connecting processors has a limited scale. In order to implement a CC-NUMA multi-processor system having a larger scale, the node controller as shown in FIG. 1 is required. The Node Controller has functions of extending the system scale and maintaining global Cache coherence. First, each node controller is connected to 1 to 4 processors, so as to form a node and a first-level Cache-coherency domain, and intra-domain Cache coherence is collectively maintained by the processors and the node controller. The node controller also occupies at least one processor ID in the domain, and therefore, the sum of the number of the processors and the number of the node controller in the domain cannot be greater than the number of processor IDs supportable by the processor in the domain. Next, node controllers are interconnected directly or are connected through a node router, so as to form a large-scale CC-NUMA system. Second-level Cache coherence among the nodes is maintained by the node controllers, and when a processor in a certain node accesses a memory of a processor in another node across nodes and Cache coherency domains, global Cache coherence is maintained by the node controllers.

A relevant model, that is, a CC-NUMA bus function model is designed accordingly: the model simulates to implement Caches, storage in processors, and an interconnection network among the processors; supports a self-defined system topological structure; supports transaction-level simulation of an access behavior; and simulates a processor direct-connection Cache coherence protocol and provides real-time behaviors and states of various access transactions, Caches and storage in the system. Moreover, a node controller simulation model is also designed: the module simulates, by using an API interface of the bus function model, to implement a multi-level Cache coherence protocol possessed by the node controller; communicates with the processors by using a processor Cache coherence protocol message, and performs communication among various node controllers through a node controller network by using an extension Cache coherence protocol message, thereby implementing coherence protocol conversion of multiple levels of domains.

A core idea of using a simulation verification method for performing function verification is comparing intensions of a designer with actual behaviors of an observation simulator, so as to determine coherence of the two. When a design can run in simulation as expected by a designer and achieve design requirements, it is considered that the design is verified. During verification, a simulation result coverage rate is analyzed for a generated test stimulation, and in combination with information exported from system function description, a test stimulation generation algorithm or a test stimulation generation constraint for further verification is improved, so that a further generated test stimulation can enable the simulation system to achieve a higher coverage rate.

A Cache coherence protocol is a processing mechanism used for implementing shared data access coherence and providing a shared storage programming interface; the Cache coherence protocol not only directly determines correctness of the system, but also plays an important role on system scale and performance, and is critical to implementing a multi-processor multi-core system with distributed and shared memories. Various factors such as rapid expansion of the system scale, uncertainty of network delay, and diversity of a storage coherence model result in an extremely complicated Cache coherence protocol, and a state space of the protocol is increased exponentially, or even exploded. In the industry, there are many discussions on a Cache coherence protocol verification method, mainly including formalized verification and software simulation verification. Because of the inherent state space explosion problem, currently, the totally formalized verification cannot be applied to a verification work of a complicated multi-level protocol. The software simulation verification can write a constraint model artificially and perform a constrained pseudo-random test, so as to verify a specific object with improved efficiency, and the software simulation verification is a practical and feasible method. The present invention, based on the software simulation method, first describes building of a simulation model in an extension Cache Coherence protocol-based multi-level coherence description manner, and provides a software simulation verification method, so as to effectively verify a multi-level domain Cache Coherence protocol in a multi-state space. Through building one multi-processor verification system model and performing relevant simulation verification, the applicability and the effectiveness of the method are further confirmed.

The number of intra-domain processor IDs supportable by the processor is limited, so that the number of node controllers required by the multi-processor system is over large, resulting in a large inter-node interconnection scale and a complicated topological structure. Building an extension Cache Coherence protocol-based multi-level coherence protocol, inquiring a local protocol table converting mechanism by using node controllers, and converting multi-level coherent domain packets can significantly extend a large-scale memory shared multi-processor system, and can effectively improve system performance and reduce system topological complexity.

### SUMMARY

Embodiments of extension Cache Coherence protocol-based multi-level coherence protocol conversion correctness test and verification method are provided, directed to a multi-layer Cache coherence protocol in a CC-NUMA system.

Embodiments disclosed herein can be implemented through the following technical solution: includes: a multi-layer Cache coherence protocol model simulation test structure; an extensible topological structure; a node simulation model; a protocol table inquiring and state converting executing method; a protocol table executing process; a transaction generator; a test evaluation method and a method for improving a coverage rate, for building a pseudo-random based simulation verification system and a simulation verification system formed by a coverage rate driven test stimulation automatic generator, by using a coverage rate driven verification strategy, wherein:
to implement a large-scale CC-NUMA multi-processor system, a node controller NC is required to expand a coherence domain space, and the node controller has two functions including maintaining global Cache coherence and extending system scale: first, each node controller is connected to 1 to 4 processors, so as to form a node and a first-level Cache coherency domain, and intra-domain coherence is collectively maintained by the processors and the node controller; next, node controllers are interconnected directly or are connected through a node router, so as to form a large-scale CC-NUMA system; second-level Cache coherence among nodes is maintained by the node controllers, and the large-scale CC-NUMA system built in this way needs to extend and establish a multi-layer protocol based on a processor direct-connection Cache coherence protocol, and maintain global coherence, and in order to build an extension Cache Coherence protocol-based multi-level coherency domain CC-NUMA system protocol simulation model, a protocol table inquiring and state converting executing mechanism in a key node of a system is required to be built, so as to ensure accuracy and stability of intra-domain and inter-domain transmission among multiple coherency domains; a credible protocol inlet conversion coverage rate evaluation driven verification method is further provided, transactions are processed by loading an optimized transaction generator push model, a coverage rate index is obtained after the operation is ended, and the verification efficiency is improved in comparison with a random transaction promoting mechanism; through building one multi-processor verification system model and performing relevant simulation verification, the applicability and the effectiveness of the method are further confirmed;

1) the multi-layer Cache coherence protocol model simulation test structure
   a system simulator of an extension Cache Coherence protocol-based multi-level coherency domain model and a model verification system executed in parallel with the system simulator are designed by using a SystemC language, the model verification system is tested by building a pseudo-random transaction generator, and system correctness determination of the model verification system is performed by using a global checker; the model verification system includes: a bus function model, a protocol reference model, a node controller simulator, a network simulator, a global checker, and a protocol inlet inquiring mechanism, wherein:
   (1) the bus function model is a clock-precise function model, simulates to implement Caches, storage controls in processors, and intra-processor and inter-processor interconnection networks, provides a transaction-level simulation support for an access and storage behavior, supports a self-defined system topological structure, provides an external API interface, which performs message interaction with an external module, simulates and provides real-time behaviors and states of various access and storage transactions, Caches, and storage controls in the system according to processor direct-connection Cache coherence protocol during running;
   (2) the protocol reference model is tightly integrated with the bus function model, performs real-time checking on a system state and a message stream in the simulation system, and is used for finding behaviors of the system deviating from the protocol during simulation;
   (3) the node controller simulator is hooked through the API interface of the bus function model, and simulates to implement a Cache coherence protocol possessed by the node controller NC; communicates with the processors by using a processor direct-connection Cache coherence protocol message, and performs communication among various NC simulators through the network simulator by using a Cache coherence protocol message thereof;
   (4) the network simulator simulates a simple non-order-preservation total-exchange network, and performs, by using the network, message communication of an extension Cache coherence protocol;
   (5) the global checker runs over the whole system, and checks global data Cache coherence through the API of the bus function model; and
   (6) the random/force test stimulation automatic generator is hooked through the API interface of the bus function model, continuously generates random/force access and storage transactions during simulation, and sends the access and storage transactions to the Caches in the bus function model through the API interface of the bus function model;
2) the extensible topological structure
   inter-node communication is performed through an inter-domain interconnection network, and packet transmission is performed by using a network interface NI, each domain includes two CPUs, each CPU is hooked to a memory so as to build a 4 Clumps-based extensible basic topological structure, that is, a topological structure of a multi-node multi-processor system in which each Clump domain is provided with 4 Nodes; addresses of a coherence space, a non-coherence space and an IO space are divided and set according to the system scale, the NC agents all remote address spaces; according to a system address mapping solution, an address area of each Clump NC node does not overlap address areas of other NC nodes, and therefore, if an address area of a packet input to the NC is not located in this Clump, a cross-Clump conversion operation is necessarily required;
3) the node simulation model
   the NC receives and processes an intra-Clump packet and an inter-Clump packet, performs corresponding recording and processing, and sends packets to the Clump and between the Clumps, the NC implements a protocol table simulator for pre-reading protocol table specific operations from a configuration file, and when the node simulator receives a message, the protocol table simulator is activated, first, an inlet condition inquirer performs searching according to the received message and a current system state, finds an inlet, and the procedure proceeds to a corresponding state converting executer to execute a corresponding state converting code; if no corresponding inlet is found, it is reported that the simulation has an error and the simulation is ended;
4) the protocol table inquiring and state converting execution, including the protocol table simulator and the inlet condition inquirer, wherein:
   the protocol table simulator is served as a core of the system simulator, the protocol table simulator is critical to normal works of a multi-layer Cache coherence protocol model; the protocol table is a verified objective, and the protocol table may be modified during the whole verification process, so that a protocol table simulator for pre-reading protocol table specific operations from a configuration file needs to be set; the simulator includes two parts: an inlet condition inquirer and a state converting executer; when the node simulator receives a message, the protocol table simulator is activated, first, the inlet condition inquirer performs searching according to the received message and a current system state, finds an inlet, and the procedure proceeds to a corresponding state converting executer to execute a corresponding state converting code; if no corresponding inlet is found, it is reported that the simulation has an error and the simulation is ended;
   the inlet condition inquirer is a critical module for executing inter-domain coherence, a coherence packet received by the node controller is converted by the two modules according to the protocol tables thereof, the inlet condition inquirer receives the packet, inquires the protocol table according to a state of the inlet condition inquirer, updates a local state, and sends a new packet, and the inlet condition inquirer records several entries of the protocol table, and structures for recording event states include a Trk (packet recording storage module)\Rdt (read packet storage module)\Wrt (write packet storage module)\Orb (send packet storage module)\Dir (directory storage module); first, a coding method of a system state register is defined: digits of a value of each state register are fixed, and therefore, after all state registers are converted to corresponding binary numbers, the maximum digits are supplemented leftwards, and all supplemented binary numbers are stringed to obtain a corresponding coding value, if the value provided in the protocol table is uncertain, the uncertain value needs to be extended to all values during coding, and all values after coding direct to the same inlet; in a configuration file of each message, sorting is performed first according to inlet condition values, and each condition is corresponding to one inlet; and
   the inlet condition inquirer adopts a hierarchical design, the first level performs inquiring for the received message, this part is designed by using a Strategy design mode, implements a message processing class for each message, and inherits a public message processing class, and when a north-bridge simulator receives a message, matching the message is performed by using a matching method in a Hash lookup table mode, so as to find a corresponding inlet rapidly;
5) the protocol table execution process
   all possible state conversions performed in the protocol table include two types: filling of a register value and sending of a message, the filling of a register uses a universal filling function, and transmits the value of the register as a parameter; for the sending of the message, different message sending functions are written according to different sending messages, various to-be-sent message functions are coded, and the codes are bound to function pointers of corresponding message sending functions, and therefore, in an operation configuration file of each message, each inlet has a corresponding register value and a message sending function code that needs to be called; and
   during execution of an actual simulator, when the inlet condition inquirer inquires a corresponding inlet, a control right is delivered to the state converting executer, and the state converting executer respectively calls, according to an operation list pre-read from the configuration file, corresponding register filling functions and message sending functions for work;
6) the transaction generator
   the work of the transaction generator is a random test, and the random test is an effective manner and process for ensuring completeness of test coverage, and the random test mainly performs retest on all important entries of the protocol, and also tests those parts not being covered by current test samples; each link has several selectable contents, various protocol entries are generated through a large amount of random links, and protocol verification is achieved through random combinations;
7) the test evaluation method and the method for improving coverage rate
   during modeling test, simulation verification is performed continuously, and if it is found there is a verification simulation result departing from a design reference, simulation implementation is modified, and simulation is performed again; and if no simulation departing from the design reference is found, it is analyzed to determine whether a target coverage rate is achieved, if the target coverage rate is not achieved, a test stimulation is modified, and the simulation is performed again; if the target coverage rate is achieved, the verification work is finished; a core technology of the coverage rate driven verification method includes coverage rate measuring and reporting and test stimulation automatic generation;
   according to the selected coverage rate driven simulation verification method, the following simulation verification process model is built: during verification, the test is formed by several simulation periods, and when each period starts, a test stimulation automatic generator generates several access transactions and injects the access transactions into a system simulator, the system simulator implements the generated access transactions through simulated running, when the access transactions generated once are all implemented, the system completes the simulation period, and after each simulation period is ended, the system takes statistics on protocol table entry coverage rate conditions, resets the simulator, and proceeds to the next simulation period;
   during simulation verification, obviously, each period has several protocol table entries being covered, and except for the protocol table entries that have been covered in the previous simulation period, newly covered protocol table entries are added protocol table coverage entries; it is set that a protocol table added in the i^{th} period is K, then the rate of increase of the coverage rate of the i^{th} period is Ki/N (N is the total entry number of the protocol table); it is set that a protocol table set covered by the t^{th} period is {Ki}, and the coverage rate after T periods is Card{KT = K1 U K2 ... KT}/N;
   a simulation period is inspected, test stimulations are generated completely randomly, and the probabilities for all entries in the protocol table being covered in any period are equal, for each protocol table entry, a simulation period is considered as a single Bernoulli trial, and if output of the simulator in this period covers the protocol table entry, it is considered that the trial is successful; otherwise, the trial fails;
   there are quite many protocol table entries in the protocol table designed for solving small-probability deadlock events, that is, various entries in the protocol table have different generation probabilities, when the number of simulation periods is increased, the number of protocol table entries being newly covered in every period must be decreased continuously, and during long-term operation, the generation of effective test stimulations must be decreased rapidly and towards 0;
   for the coverage rate driven test stimulation automatic generator, it can be known from the above analysis that using pure random test stimulation generator inevitably cannot perform high-efficient verification, and in order to improve the efficiency of the test, a test stimulation generated every time must be directive, so that the simulator covers, in a larger probability, protocol table entries that have not been covered, and this is an inevitable requirement for the coverage rate driven verification method; accordingly, two methods for adjusting a test stimulation generation by the coverage rate driven test stimulation automatic generator according to the change of the coverage rate are described as follows:
   (1) because of complexity of verifying a target protocol, and diversity of an access transaction implementation process brought by the non-order-preservation network, it is almost impossible to analyze the relationship between a specific input test stimulation and an output coverage target, in this condition, it is considered to introduce a test stimulation classifier, the classifier can provide a probability relationship between an input test stimulation and an output coverage rate, and the classifier is used to filter randomly generated test stimulations, so as to choose a test stimulation having a large probability of generating a new coverage target to serve as an effective stimulation to be executed in the simulation, and ineffective test stimulations are discarded; and
   (2) the protocol table is analyzed, and a large number of protocol table entries in the protocol table have similar entries, including many protocol table entries specifically designed for small-probability events, and therefore, a bias idea is introduced in generation of the test stimulations in a relevant analysis based method, and after the simulation of every period is ended, the test stimulation in this period is biased, and the biased test stimulation is sent to the simulator again for running, so as to rapidly cover protocol table entries similar to the simulation verification result generated in the previous period.

The embodiments disclosed herein has the following outstanding beneficial effects: international complicated Cache Coherence computer system verifications generally have the problems of verification system scale selection and extremely high difficulty in protocol design verification. The embodiments disclosed herein is to build an extension Cache Coherence protocol-based multi-level coherence protocol conversion correctness test verification model. The number of intra-domain processor IDs supportable by a processor is limited, so that the number of node controllers required by a multi-processor system is overlarge, resulting in a huge inter-node interconnection scale and a complicated topological structure. Building an extension Cache Coherence protocol-based multi-level coherence protocol, inquiring a local protocol table converting mechanism by using node controllers, and converting multi-level coherent domain packets can significantly extend a large-scale memory shared multi-processor system, and can effectively improve system performance and reduce system topological complexity. A complete verification method is designed and implemented, directed to a multi-layer Cache coherence protocol in a CC-NUMA system. The method uses a coverage rate driven verification strategy, and a verification system is formed by a pseudo-random based simulation verification system and a coverage rate driven test stimulation automatic generator.

The embodiments disclosed herein mainly has the following advantages:
1. A simulation modeling manner implements protocol design verification of a large-scale extension Cache Coherence protocol-based multi-level coherence computer system, and implements verification of a key protocol of the large-scale computer system within a short period of time by using extremely low financing cost and personnel cost;
2. A counter-example of the key protocol of the large-scale computer system can be found rapidly, and fault tracing can be performed because of completeness of a modeling record, thereby guiding modification of the key protocol; and
3. A standard model is built, so as to guide building of an interconnection chip of a large-scale extension Cache Coherence protocol-based multi-level coherence computer system. Verification coverage rates of the computer system and a key chipset thereof are ensured, and item design verification cost is greatly saved, thereby ensuring a development cycle.

### BRIEF DESCRIPTION OF THE DRAWINGS

FIG. 1 is a topological structural diagram of a multi-level coherency domain system having node controllers;
FIG. 2 is a schematic diagram of a coherence protocol model simulation test structure;
FIG. 3 is a schematic diagram of a basic structure of an interconnection network of a multi-node multi-processor system;
FIG. 4 is a schematic diagram of a topological structure of a multi-node multi-processor system
FIG. 5 is a key structure diagram of a node simulation model
FIG. 6 is a diagram of an execution process of a simulator
FIG. 7 is a diagram of an execution process of a transaction generator;
FIG. 8 is a flow chart of a coverage rate driven double-loop verification work; and

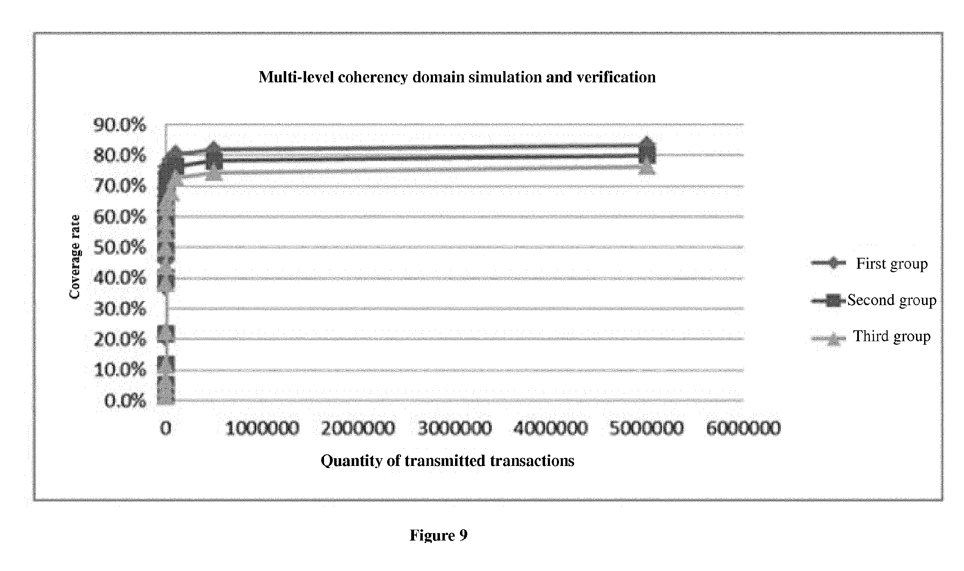

FIG. 9 is a curve graph of simulation and verification of a multi-level coherency domain.

### DETAILED DESCRIPTION

The method disclosed herein is further described in detail below in combination with the accompanying drawings.

### 1) A multi-layer Cache coherence protocol model simulation test structure

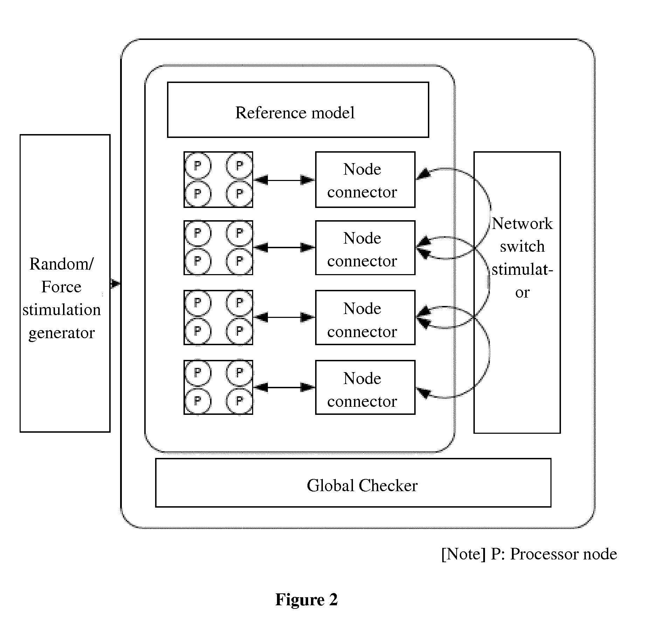

This system designs and implements a full-system simulator by using a SystemC language, thereby implementing a simulation paralleling method; model verification is performed by building a pseudo-random software simulation verification system in a SystemC environment, and a structure thereof is shown in FIG. 2;

The verification system mainly includes the following parts:
(1) a bus function model: the bus function model is a clock-precise function model, simulates to implement Caches, storage controls in processors, and intra-processor and inter-processor interconnection networks; provides a transaction-level simulation support for an access behavior; supports a self-defined system topological structure; provides an external API interface, which can perform message interaction with an external module; simulates according to a processor direct-connection Cache coherence protocol during running, and provides real-time behaviors and states of various access transactions, Caches, and storage controls in the system;
(2) a Reference Model (protocol reference model): the Reference Model is tightly integrated with the bus function model, performs real-time checking on a system state and a message stream in the simulation system, and is used for finding behaviors of the system deviating from the protocol during simulation;
(3) a Node Controller (node controller simulator): the Node Controller is hooked through the API interface of the bus function model, and simulates to implement a Cache coherence protocol possessed by the Node Controller (NC); communicates with the processors by using a processor direct-connection Cache coherence protocol message, and performs communication among various NC simulators through a network simulator by using a Cache coherence protocol message thereof;
(4) a Network Simulator (network simulator): the Network Simulator simulates a simple non-order-preservation total-exchange network, and performs, by using the network, message communication of an extension Cache coherence protocol;
(5) a Global Checker (global checker): the Global Checker runs over the whole system, and checks global data Cache coherence through the API of the bus function model; and
(6) a Random/Force Test Stimulation Generator (random/force test stimulation automatic generator): the Random/Force Test Stimulation Generator is hooked through the API interface of the bus function model, continuously generates random/force access transactions during simulation, and sends the access transactions to the Caches in the bus function model through the API interface of the bus function model;

### 2) An extensible topological structure

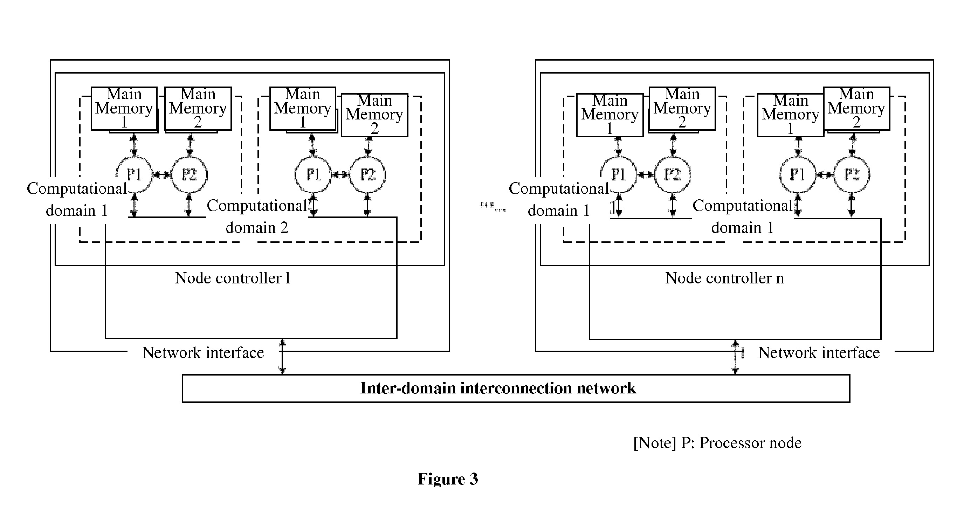

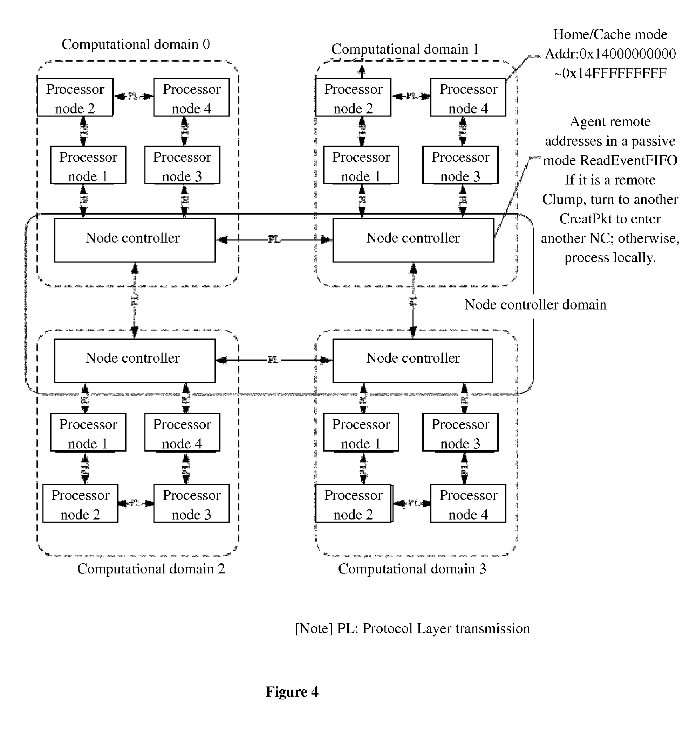

In this design, a basic structure of an interconnection network of a multi-node multi-processor system is shown in FIG. 3, inter-node communication is performed through an inter-domain interconnection network, and packet transmission is performed through a Network Interface (NI). Each Domain includes two CPUs (marked as P in FIG. 3), and each CPU is hooked to a Memory (MEM) storage space. A 4 Clumps-based extensible basic topological structure is built, and a topological structure of a multi-node multi-processor system in which each Clump domain is provided with 4 Nodes is shown in FIG. 1. Addresses of a coherence space, a non-coherence space and an IO space are divided and set according to the system scale. The NC agents all remote address spaces, and according to a system address mapping solution, as shown in FIG. 4, an address area of each Clump NC node does not overlap address areas of other NC nodes, and therefore, if an address area of a packet input to the NC is not located in this Clump, a cross-Clump conversion operation is necessarily required;

### 3) A node simulation model

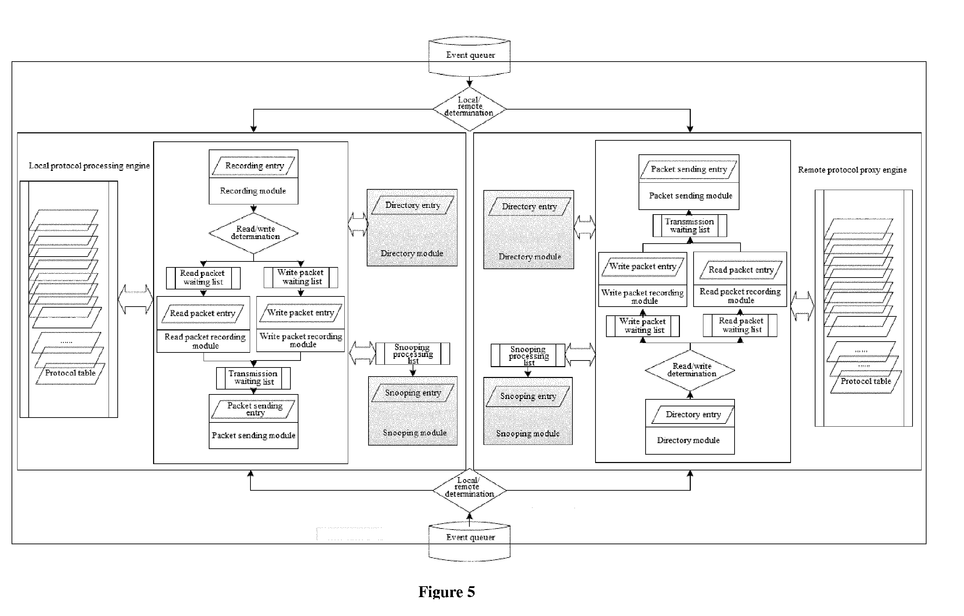

The NC receives and processes an intra-Clump packet and an inter-Clump packet, performs corresponding recording and processing, and sends the packets to the Clump and between the Clumps. The NC implements a protocol table simulator for pre-reading protocol table specific operations from a configuration file. When the node simulator receives a message, the protocol table simulator is activated; first, an inlet condition inquirer performs searching according to the received message and a current system state, finds an inlet, and the procedure proceeds to a corresponding state converting executer to execute a corresponding state converting code, and if no corresponding inlet is found, it is reported that the simulation has an error and the simulation is ended. For example, FIG. 5 shows a key structure of a node simulation model;

### 4) Protocol table inlet inquiring

A Protocol Engine is a critical module for executing inter-domain coherence. A coherence packet received by the node controller is converted by the two modules according to the protocol tables thereof. The Protocol Engine module receives the packet, inquires the protocol table according to a state of the Protocol Engine, updates a local state, and sends a new packet. The Protocol Engine records several entries of the protocol table, and structures for recording event states include a Trk (packet record storage module)\Rdt (read packet storage module)\Wrt (write packet storage module)\Orb (send packet storage module)\Dir (directory storage module), thereby implementing storage and inquiry of the state structures;

For example, the protocol table is as that shown in the following table:

| Current State | Next State | | | | | | |
|---|---|---|---|---|---|---|---|
| **Home Chain** | **ReqTrk** | | | | | | **HomeChan** |
| **HOM Req** | **State** | **Address** | **Cmd** | **NotOwn** | **Rcvd** | **WbMark** | **Msg** |
| RdCode | Busy | Msg. Addr | RdCode | FALSE | +{Req} | | Remove |
| RdData | | | RdData | | | | |
| RdDataMigratory | | | RdDataMigratory | | | | |
| RdCur | | | RdCur | TURE | | | |

First, a coding method of a system state register is defined: digits of a value of each state register are fixed, and therefore, after all state registers are converted to corresponding binary numbers, the maximum digits are supplemented leftwards, and all supplemented binary numbers are stringed to obtain a corresponding coding value. If the value provided in the protocol table is uncertain, the uncertain value needs to be extended to all values during coding, and all values after coding direct to the same inlet. In a configuration file of each message, sorting is performed first according to inlet condition values, and each condition is corresponding to one inlet;

The inquirer adopts a hierarchical design, the first level performs inquiring for the received message, and this part is designed by using a Strategy design mode, implements a message processing class for each message, and inherits a public message processing class. When a north-bridge simulator receives a message, matching the message is performed by using a matching method in a Hash lookup table mode, so as to find a corresponding inlet rapidly;

### 5) A protocol table execution process

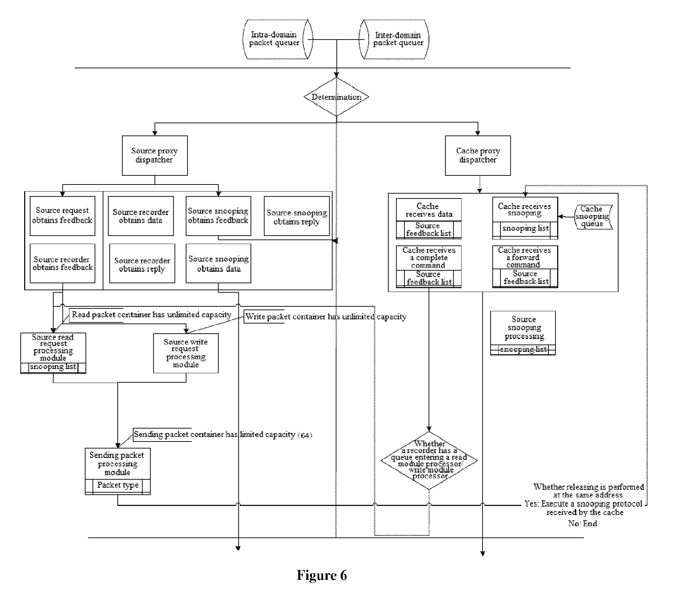

A process of a Protocol Engine executing a protocol table is shown by a simulator execution process in FIG. 6, and each block represents that a protocol table conversion is completed. A block in dashed lines only executes one corresponding protocol table. All possible state conversions that may be performed in the protocol table include two types: filling of a register value and sending of a message. The filling of a register uses a universal filling function, and transmits the value of the register as a parameter; for the sending of the message, different message sending functions are written according to different sending messages, various to-be-sent message functions are coded, and the codes are bound to function pointers of corresponding message sending functions. Therefore, in an operation configuration file of each message, each inlet has a corresponding register value and a message sending function code that needs to be called.

During execution of an actual simulator, when the inlet condition inquirer inquires a corresponding inlet, a control right is delivered to the state converting executer, and the state converting executer respectively calls, according to an operation list pre-read from the configuration file, corresponding register filling functions and message sending functions for work;

### 6) A transaction generator

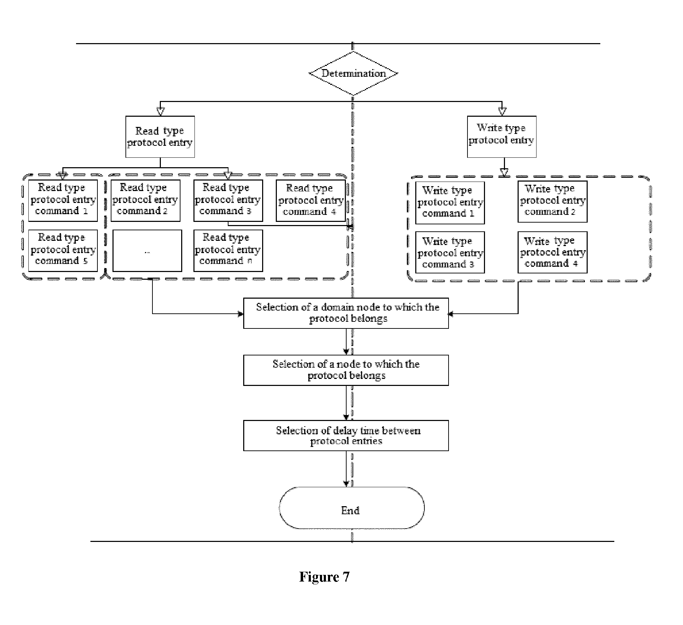

The work of the transaction generator is a random test. The random test is an effective manner and process for ensuring completeness of test coverage. The random test mainly performs retest on all important entries of the protocol, and also tests those parts not being covered by current test samples. As shown in an execution process of the transaction generator in FIG. 7, each link has several selectable contents, various protocol entries are generated through a large amount of random links, and protocol verification is achieved through random combination;

### 7) A test evaluation method and a method for improving coverage rate

During modeling test, simulation verification is performed continuously, and if it is found there is a verification simulation result departing from a design reference, simulation implementation is modified, and simulation is performed again; and if no simulation departing from the design reference is found, it is analyzed to determine whether a target coverage rate is achieved, if the target coverage rate is not achieved, a test stimulation is modified, and the simulation is performed again; if the target coverage rate is achieved, the verification work is finished. A core technology of the coverage rate driven verification method includes coverage rate measuring and reporting and test stimulation automatic generation.

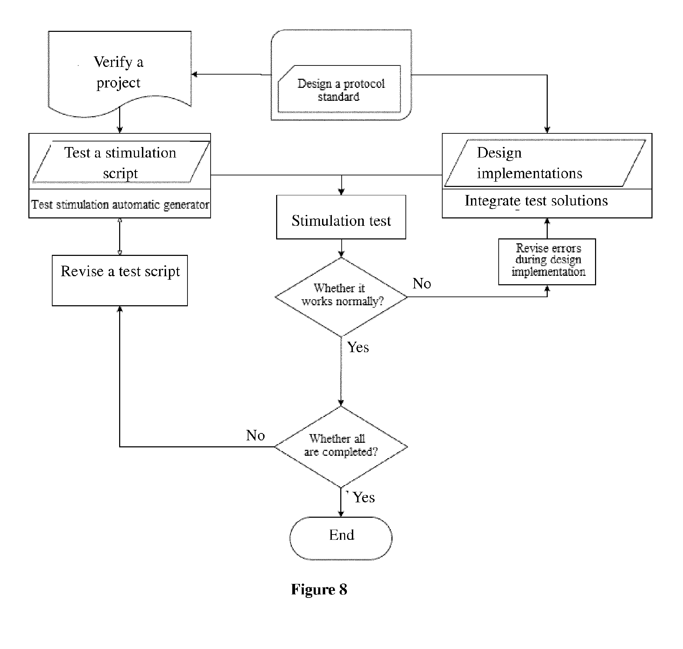

FIG. 8 is a flow chart of a coverage rate driven double-loop verification work.

According to the selected coverage rate driven simulation verification method, the following simulation verification process model is built: during verification, the test is formed by several simulation periods, and when each period starts, a test stimulation automatic generator generates several access transactions and injects the access transactions into a system simulator, the system simulator implements the generated access transactions through simulated running, when the access transactions generated once are all implemented, the system completes the simulation period. After each simulation period is ended, the system takes statistics on protocol table entry coverage rate conditions, resets the simulator, and proceeds to the next simulation period.

During simulation verification, obviously, each period has several protocol table entries being covered, and except for the protocol table entries that have been covered in the previous simulation period, newly covered protocol table entries are added protocol table coverage entries, and it is set that a protocol table added in the i^{th} period is Ki, then the rate of increase of the coverage rate of the i^{th} period is Ki/N (N is the total entry number of the protocol table). It is set that a protocol table set covered by the t^{th} period is {Ki}, the coverage rate after T periods is Card{ KT = K1 U K2 ... KT}/N.

There are quite many protocol table entries in the protocol table designed for solving small-probability deadlock events, that is, various entries in the protocol table have different generation probabilities. When the number of simulation periods is increased, the number of protocol table entries being newly covered in every period must be decreased continuously, and during long-term operation, the generation of effective test stimulations must be decreased rapidly and towards 0.

It can be known from the above analysis that using pure random test stimulation generator inevitably cannot perform high-efficient verification, and in order to improve the efficiency of the test, a test stimulation generated every time must be directive, so that the simulator covers, in a larger probability, protocol table entries that have not been covered, and this is an inevitable requirement for the coverage rate driven verification method. Accordingly, two methods for adjusting test stimulation generation according to the change of the coverage rate are described as follows:
1. Because of complexity of verifying a target protocol, and diversity of an access transaction implementation process brought by the non-order-preservation network, it is impossible to analyze the relationship between a specific input test stimulation and an output coverage targets. In this condition, it is considered to introduce a test stimulation classifier, and the classifier can provide a probability relationship between a input test stimulation and an output coverage rate. The classifier is used to filter randomly generated test stimulations, so as to choose a test stimulation having a large probability of generating a new coverage target to serve as an effective stimulation to be executed in the simulation, and ineffective test stimulations are discarded;
2. The protocol table is analyzed, and a large number of protocol table entries in the protocol table have similar entries, including many protocol table entries specifically designed for small-probability events, and therefore, a bias idea may be introduced in generation of the test stimulations in a relevant analysis based method. After the simulation of every period is ended, the test stimulation in this period is biased, and the biased test stimulation is sent to the simulator again for running, so as to rapidly cover protocol table entries similar to the simulation verification result generated in the previous period.

The embodiments disclosed herein are applied to the design field of a complicated high-end computer system, and has an extremely high application value in design verification of a large-scale high-end computer system and design verification of a key chipset of the computer system, and even in design and development of the system OS and application software of the computer system.

The embodiments disclosed herein are used during research of a key support technology of an 863 subject cloud data center. Single transaction simulation time is measured after a model is built. In a simulator, a simulation time is set, and time required to be consumed during simulation clock proceeding is tested. At the same time, an actual execution time length is obtained in an Inspur NF8520 server including processor Intel E7540XM2×4, memory 4G×16, and platform CentOS4.8, as shown in the following drawing. An actual test result indicates that, a multi-level coherence protocol verification model provided in this text based on a software simulation method verifies a Cache Coherence protocol in a multi-state space under an acceptable processing simulation time.

During development of a large-scale CC-NUMA multi-processor system computer, content of the embodiments disclosed herein ensures feasibility of designs in various aspects including item architecture design, system interconnection design and protocol processing key chip protocol design, especially provides a key and reliable comparison model for design of multiple key chipsets of the system, and ensures successful design of a multi-path computer system with smaller design scale and fewer investment cost, thereby having an extremely important development and application value.

### Status analysis of foreign market technology and necessity of application

Various factors such as rapid extension of a system scale, uncertainty of network delay, and diversity of a storage coherence model result in an extremely complicated Cache coherence protocol, and a state space of the protocol is increased exponentially, or even exploded. In the industry, there are many discussions on a Cache coherence protocol verification method, mainly including formalized verification and software simulation verification. Because of the inherent state space explosion problem, currently, the totally formalized verification cannot be applied to a verification work of a complicated multi-level protocol. The software simulation verification can write a constraint model artificially and perform a constrained pseudo-random test to verify a specific object with improved efficiency, and is a practical and feasible method. A verification evaluation system is implemented by simulating a structure of an actual computer system, a verification evaluation platform is modeled, so as to implement verification of a key protocol of a large-scale computer system within a short period of time by using extremely low financing cost and personnel cost; during modeling, recording of all states of a processing mechanism may be implemented, and fault tracing is easily performed when a counter-example of the key protocol of the large-scale computer system is found. The modeling implements a standard model, and guides building of an interconnection chip of a large scale extension Cache Coherence protocol-based multi-level coherence computer system. The modeling scale is autonomous and controllable, technical conditions are mature, and during implementation, manufacturing and development costs are easily controlled, thereby preventing an over-long development cycle.

### Benefits (economic benefits and social benefits)

In relation to a high-end fault-tolerant computer system with an extremely complicated structure, a key technology of a design of the embodiments disclosed herein includes design of a system structure, design of a key chipset, and the like. A small-scale prototype verification system may be implemented by using small-scale hardware, and breakthrough of the key technology of system design is implemented by a programmable FPGA chip, thereby shortening the development cycle, reducing design verification cost, and ensuring that project development is successful. For example, during designing of a key chipset with complicated protocol and logic, the cost of taping out the chip once is dozens of millions of Yuan, a tape-out period lasts several months, and a prototype verification system having high verification coverage rate may ensure success of taping out the chip once, thereby greatly saving time overhead and cost overhead of the project. Moreover, the verification also provides references to system structure design, heat dissipation design, and power consumption analysis, so as to greatly reduce development risk of the project. Therefore, the embodiments disclosed herein have high economic benefits and social benefits.

In the present invention, except for technical features disclosed in the specification of the present invention, others technologies are well-known by persons skilled in the art.

## Claims

1. An extension Cache Coherence protocol-based multi-level coherency domain simulation verification and test method, comprising:
a multi-layer Cache coherence protocol model simulation test structure; an extensible topological structure; a node simulation model; a protocol table inquiring and state converting executing method; a protocol table executing process; a transaction generator; a test evaluation method and a method for improving a coverage rate, for building a pseudo-random based simulation verification system and a simulation verification system formed by a coverage rate driven test stimulation automatic generator, by using a coverage rate driven verification strategy, wherein:
to implement a large-scale CC-NUMA multi-processor system, a node controller NC is required to expand a coherence space, and the node controller has two functions comprising maintaining global Cache coherence and extending system scale: first, each node controller is connected to 1 to 4 processors, so as to form a node and a first-level Cache-coherency domain, and intra-domain coherence is collectively maintained by the processors and the node controller; next, node controllers are interconnected directly or are connected through a node router, so as to form a large-scale CC-NUMA system; second-level Cache coherence among nodes is maintained by the node controllers, and the large-scale CC-NUMA system built in this way needs to extend and establish a multi-layer protocol based on a processor direct-connection Cache coherence protocol, and maintain global coherence, and in order to build an extension Cache Coherence protocol-based multi-level coherency domain CC-NUMA system protocol simulation model, a protocol table inquiring and state converting executing mechanism in a key node of a system is required to be built, so as to ensure accuracy and stability of intra-domain and inter-domain transmission among multiple coherency domains; a credible protocol inlet conversion coverage rate evaluation driven verification method is further provided, transactions are processed by loading an optimized transaction generator push model, a coverage rate index is obtained after the operation is ended, and the verification efficiency is improved in comparison with a random transaction promoting mechanism; through building one multi-processor verification system model and performing relevant simulation verification, the applicability and the effectiveness of the method are further confirmed;
1) the multi-layer Cache coherence protocol model simulation test structure
a system simulator of an extension Cache Coherence protocol-based multi-level coherency domain model and a model verification system executed in parallel with the system simulator are designed by using a SystemC language, the model verification system is tested by building a pseudo-random transaction generator, and system correctness determination of the model verification system is performed by using a global checker; the model verification system comprises: a bus function model, a protocol reference model, a node controller simulator, a network simulator, a global checker, and a protocol inlet inquiring mechanism, wherein:
(1) the bus function model is a clock-precise function model, simulates to implement Caches, storage controls in processors, and intra-processor and inter-processor interconnection networks, provides a transaction-level simulation support for an access behavior, supports a self-defined system topological structure, provides an external API interface, which performs message interaction with an external module, simulates according to processor direct-connection Cache coherence protocol during running, and provides real-time behaviors and states of various access transactions, Caches, and storage controls in the system;
(2) the protocol reference model is tightly integrated with the bus function model, performs real-time checking on a system state and a message stream in the simulation system, and is used for finding behaviors of the system deviating from the protocol during simulation;
(3) the node controller simulator is hooked through the API interface of the bus function model, and simulates to implement a Cache coherence protocol possessed by the node controller NC; communicates with the processors by using a processor direct-connection Cache coherence protocol message, and performs communication among various NC simulators through the network simulator by using a Cache coherence protocol message thereof;
(4) the network simulator simulates a simple non-order-preservation total-exchange network, and performs, by using the network, message communication of an extension Cache coherence protocol;
(5) the global checker runs over the whole system, and checks global data Cache coherence through the API of the bus function model; and
(6) the random/force test stimulation automatic generator is hooked through the API interface of the bus function model, continuously generates random/force access transactions during simulation, and sends the access transactions to the Caches in the bus function model through the API interface of the bus function model;
2) the extensible topological structure
inter-node communication is performed through an inter-domain interconnection network, and packet transmission is performed by using a network interface NI, each domain comprises two CPUs, each CPU is hooked to a memory so as to build a 4 Clumps-based extensible basic topological structure, that is, a topological structure of a multi-node multi-processor system in which each Clump domain is provided with 4 Nodes; addresses of a coherence space, a non-coherence space and an IO space are divided and set according to the system scale, the NC agents all remote address spaces; according to a system address mapping solution, an address area of each Clump NC node does not overlap address areas of other NC nodes, and therefore, if an address area of a packet input to the NC is not located in this Clump, a cross-Clump conversion operation is necessarily required;
3) the node simulation model
the NC receives and processes an intra-Clump packet and an inter-Clump packet, performs corresponding recording and processing, and sends packets to the Clump and between the Clumps, the NC implements a protocol table simulator for pre-reading protocol table specific operations from a configuration file, and when the node simulator receives a message, the protocol table simulator is activated, first, an inlet condition inquirer performs searching according to the received message and a current system state, finds an inlet, and the procedure proceeds to a corresponding state converting executer to execute a corresponding state converting code; if no corresponding inlet is found, it is reported that the simulation has an error and the simulation is ended;
4) the protocol table inquiring and state converting execution, comprising the protocol table simulator and the inlet condition inquirer, wherein:
the protocol table simulator is served as a core of the system simulator, the protocol table simulator is critical to normal works of a multi-layer Cache coherence protocol model; the protocol table is a verified objective, and the protocol table may be modified during the whole verification process, so that a protocol table simulator for pre-reading protocol table specific operations from a configuration file needs to be set; the simulator comprises two parts: an inlet condition inquirer and a state converting executer; when the node simulator receives a message, the protocol table simulator is activated, first, the inlet condition inquirer performs searching according to the received message and a current system state, finds an inlet, and the procedure proceeds to a corresponding state converting executer to execute a corresponding state converting code; if no corresponding inlet is found, it is reported that the simulation has an error and the simulation is ended;
the inlet condition inquirer is a critical module for executing inter-domain coherence, a coherence packet received by the node controller is converted by the two modules according to the protocol tables thereof, the inlet condition inquirer receives the packet, inquires the protocol table according to a state of the inlet condition inquirer, updates a local state, and sends a new packet, and the inlet condition inquirer records several entries of the protocol table, and structures for recording event states comprise a Trk\Rdt\Wrt\Orb\Dir, implementing storage and inquiry of the state structures;
first, a coding method of a system state register is defined: digits of a value of each state register are fixed, and therefore, after all state registers are converted to corresponding binary numbers, the maximum digits are supplemented leftwards, and all supplemented binary numbers are stringed to obtain a corresponding coding value, if the value provided in the protocol table is uncertain, the uncertain value needs to be extended to all values during coding, and all values after coding direct to the same inlet; in a configuration file of each message, sorting is performed first according to inlet condition values, and each condition is corresponding to one inlet; and
the inlet condition inquirer adopts a hierarchical design, the first level performs inquiring for the received message, this part is designed by using a Strategy design mode, implements a message processing class for each message, and inherits a public message processing class, and when a north-bridge simulator receives a message, matching the message is performed by using a matching method in a Hash lookup table mode, so as to find a corresponding inlet rapidly;
5) the protocol table execution process
all possible state conversions performed in the protocol table comprise two types: filling of a register value and sending of a message, the filling of a register uses a universal filling function, and transmits the value of the register as a parameter; for the sending of the message, different message sending functions are written according to different sending messages, various to-be-sent message functions are coded, and the codes are bound to function pointers of corresponding message sending functions, and therefore, in an operation configuration file of each message, each inlet has a corresponding register value and a message sending function code that needs to be called; and
during execution of an actual simulator, when the inlet condition inquirer inquires a corresponding inlet, a control right is delivered to the state converting executer, and the state converting executer respectively calls, according to an operation list pre-read from the configuration file, corresponding register filling functions and message sending functions for work;
6) the transaction generator
the work of the transaction generator is a random test, and the random test is an effective manner and process for ensuring completeness of test coverage, and the random test mainly performs retest on all important entries of the protocol, and also tests those parts not being covered by current test samples; each link has several selectable contents, various protocol entries are generated through a large amount of random links, and protocol verification is achieved through random combinations;
7) the test evaluation method and the method for improving coverage rate
during modeling test, simulation verification is performed continuously, and if it is found there is a verification simulation result departing from a design reference, simulation implementation is modified, and simulation is performed again; and if no simulation departing from the design reference is found, it is analyzed to determine whether a target coverage rate is achieved, if the target coverage rate is not achieved, a test stimulation is modified, and the simulation is performed again; if the target coverage rate is achieved, the verification work is finished; a core technology of the coverage rate driven verification method comprises coverage rate measuring and reporting and test stimulation automatic generation;
according to the selected coverage rate driven simulation verification method, the following simulation verification process model is built: during verification, the test is formed by several simulation periods, and when each period starts, a test stimulation automatic generator generates several access transactions and injects the access transactions into a system simulator, the system simulator implements the generated access transactions through simulated running, when the access transactions generated once are all implemented, the system completes the simulation period, and after each simulation period is ended, the system takes statistics on protocol table entry coverage rate conditions, resets the simulator, and proceeds to the next simulation period;
during simulation verification, obviously, each period has several protocol table entries being covered, and except for the protocol table entries that have been covered in the previous simulation period, newly covered protocol table entries are added protocol table coverage entries; it is set that a protocol table added in the i^{th} period is K, then the rate of increase of the coverage rate of the i^{th} period is Ki/N (N is the total entry number of the protocol table); it is set that a protocol table set covered by the t^{th} period is {Ki}, and the coverage rate after T periods is Card{KT = K1 U K2 ... KT}/N;
a simulation period is inspected, test stimulations are generated completely randomly, and the probabilities for all entries in the protocol table being covered in any period are equal, for each protocol table entry, a simulation period is considered as a single Bernoulli trial, and if output of the simulator in this period covers the protocol table entry, it is considered that the trial is successful; otherwise, the trial fails;
there are quite many protocol table entries in the protocol table designed for solving small-probability deadlock events, that is, various entries in the protocol table have different generation probabilities, when the number of simulation periods is increased, the number of protocol table entries being newly covered in every period must be decreased continuously, and during long-term operation, the generation of effective test stimulations must be decreased rapidly and towards 0;
for the coverage rate driven test stimulation automatic generator, it can be known from the above analysis that using pure random test stimulation generator inevitably cannot perform high-efficient verification, and in order to improve the efficiency of the test, a test stimulation generated every time must be directive, so that the simulator covers, in a larger probability, protocol table entries that have not been covered, and this is an inevitable requirement for the coverage rate driven verification method; accordingly, two methods for adjusting a test stimulation generation by the coverage rate driven test stimulation automatic generator according to the change of the coverage rate are described as follows:
(1) because of complexity of verifying a target protocol, and diversity of an access transaction implementation process brought by the non-order-preservation network, it is almost impossible to analyze the relationship between a specific input test stimulation and an output coverage target, in this condition, it is considered to introduce a test stimulation classifier, the classifier can provide a probability relationship between an input test stimulation and an output coverage rate, and the classifier is used to filter randomly generated test stimulations, so as to choose a test stimulation having a large probability of generating a new coverage target to serve as an effective stimulation to be executed in the simulation, and ineffective test stimulations are discarded; and
(2) the protocol table is analyzed, and a large number of protocol table entries in the protocol table have similar entries, comprising many protocol table entries specifically designed for small-probability events, and therefore, a bias idea is introduced in generation of the test stimulations in a relevant analysis based method, and after the simulation of every period is ended, the test stimulation in this period is biased, and the biased test stimulation is sent to the simulator again for running, so as to rapidly cover protocol table entries similar to the simulation verification result generated in the previous period.
